# EUROPEAN PATENT APPLICATION

(11) **EP 0 663 597 A2**
(43) Date of publication of application: **19.07.1995**
(21) Application number: 94303713.5
(22) Date of filing: 24.05.1994
(51) Int. Cl.: G01R 13/32

(54) **Dual comparator trigger circuit with independent voltage level adjustment**

(30) Priority: 13.01.1994 US 180633
(71) Applicant: FLUKE CORPORATION, Everett, Washington 98206-9090 (US)
(72) Inventor: Holmdahl, Todd A., Bothell, Washington 98012 (US)
(74) Representative: Burke, Steven David

(57) **Abstract**

A trigger circuit for frequency and continuity measurements includes two comparators and two programmable voltage references for providing a hysteresis band with independently programmable and precisely controlled upper and lower voltage limits. Two latches coupled respectively to each comparator provide for continuity measurements.

## Description

### Background of the Invention

This invention relates generally to trigger circuits and in particular to a trigger circuit with independently programmable limit voltages for frequency measurement and continuity detection.

Signal frequency measurement is a common measurement mode in digital multimeters (DMM's). Such signals to be measured are typically sinusoidal and may have extraneous noise added, making the task of getting an accurate frequency measurement more difficult. Accurately measuring the signal frequency requires a trigger circuit capable of discriminating between the desired signal and any noise present and converting the desired signal into a digital pulse stream that is representative of the signal frequency. The frequency is then calculated using commonly available digital circuits.

Hysteresis (herein defined as a voltage band having upper and lower limits) must be added to the trigger circuit to gain noise immunity. Hysteresis requires that the signal voltage pass from one edge of a hysteresis band to the other in order for the trigger circuit output to change states. The width of the hysteresis band can be optimally set to provide maximum rejection of input noise while maintaining adequate sensitivity to the desired signal. Adjusting the direct current (D.C.) offset of the hysteresis band is desirable to compensate for any input offset in order to provide an optimum trigger point.

A single comparator circuit is the most common implementation of such a trigger circuit. Trigger circuits using a single comparator provide for adjustment of the width of the hysteresis band by direct control of the hysteresis band within the comparator itself. A programming voltage or current is injected into an external control connection on the comparator. The D.C. offset of the hysteresis band is created by imposing a D.C. offset voltage on the inverting input of the comparator. Such an arrangement does not allow for the independent adjustment of the upper and lower voltage limits of the hysteresis band. Furthermore, the width of the hysteresis band is subject to process variations of the comparator and the exact hysteresis band width may vary from one comparator to another.

Continuity detection is another common measurement mode of DMM's. Continuity detection is used to quickly trace open and shorted connections in a device under test. While prior art continuity checks typically involve a resistance measurement, another method is to determine whether an open circuit voltage exists. This gives rise to testing for voltage levels to make continuity checks.

### Summary of the Invention

In accordance with the present invention, a dual comparator trigger circuit is provided with independent control of upper and lower voltage limits of the hysteresis band. The upper and lower limit voltages are precisely set with digital-to-analog converters (DAC's) which are digitally programmable via a parallel data bus which can be connected to a microprocessor or digital controller. The outputs of the comparators are connected to a bistable circuit which toggles in response to the signal voltage passing through the upper and lower limit voltage values, thereby emulating a hysteresis band when the DMM is operating in frequency measurement mode.

With the DMM operating in continuity detection mode, the presence of an open or short circuit between the DMM test leads is translated into an input signal voltage that is capable of being detected by the dual comparator trigger circuit. The input signal may be a high voltage level corresponding to an open circuit across the DMM test leads and a low voltage level corresponding to a short circuit across the DMM test leads. The upper and lower limit voltages are set to values appropriate for detecting open and short circuits between the multimeter leads and the output of each comparator is connected to a latch which stores the output state of each comparator.

One feature of the present invention is to provide independent control of upper and lower hysteresis limit voltages for a trigger circuit.

Another feature of the present invention is to provide more precisely controlled upper and lower hysteresis limit voltages that are not process-dependent on the characteristics of any particular comparator.

Another feature of the present invention is to provide detection for continuity.

Other features, attainments, and advantages will become apparent to those skilled in the art upon a reading of the following description when taken in conjunction with the accompanying drawings.

### Brief Description of the Drawings

FIG. 1A is a graph of an input signal and the operation of a trigger circuit with an incorrectly adjusted hysteresis band;
FIG. 1B is a graph of the same input signal and the operation of a trigger circuit with a correctly adjusted hysteresis band;
FIG. 2 is a schematic of a prior art trigger circuit using one comparator; and
FIG. 3. is a detailed circuit schematic of a dual comparator trigger circuit in accordance with the present invention.

### Detailed Description of the Invention

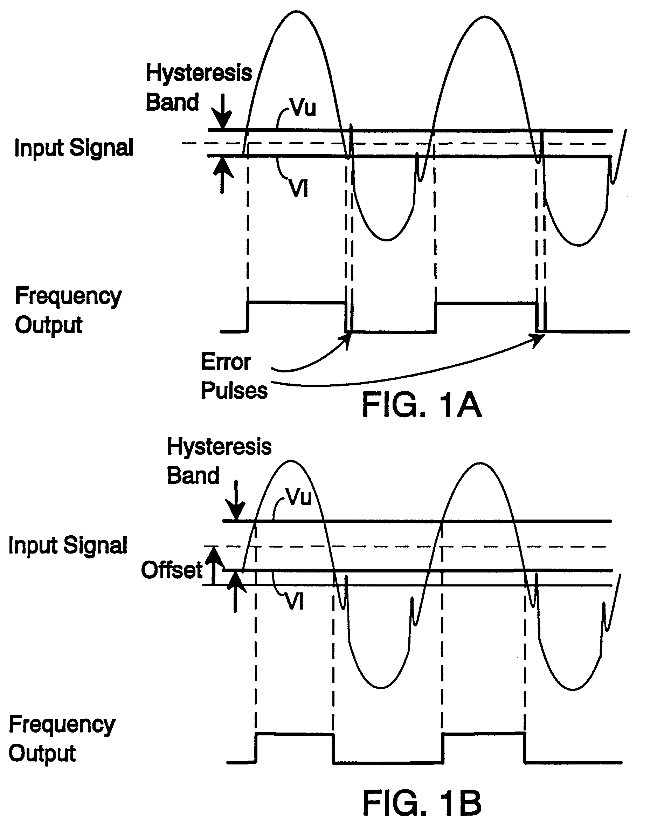

Before discussing detailed circuit operation, an overview of trigger circuits and the role of hysteresis bands will be provided. Referring to FIG. 1A, there is shown a sinusoidal input signal with common-mode noise impulses added. A hysteresis band having an upper voltage limit Vu and a lower voltage limit Vl is shown superimposed on an input signal to a trigger circuit. The output of the trigger circuit, labeled Frequency Output, changes states as the input signal voltage passes across the hysteresis band. As illustrated, the width of the hysteresis band is narrow enough that the noise impulses present on the input signal can traverse the hysteresis band, causing undesired error pulses to be generated which corrupt an attempted frequency measurement of the signal. Referring now to FIG. 1B, the hysteresis band has been widened and its D.C. offset level adjusted to obtain an output from the trigger circuit that accurately reflects the actual frequency of the input signal free of errors from the noise impulses.

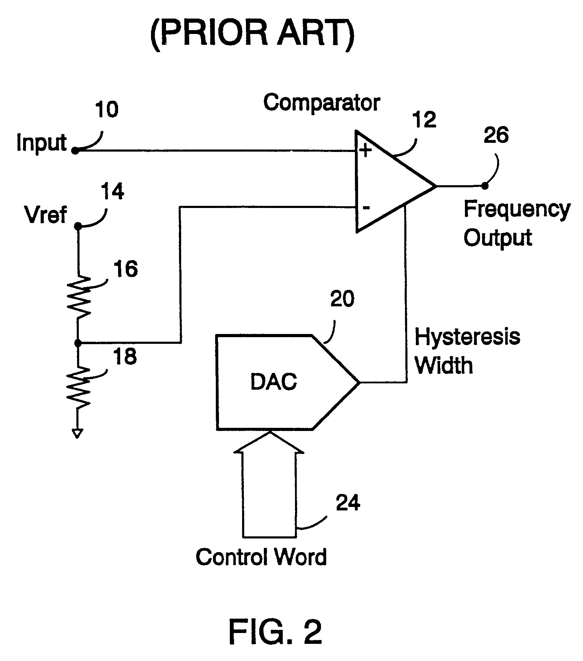

FIG. 2 illustrates a prior art single comparator trigger circuit used to measure frequency in a handheld digital multimeter. The input signal is applied to an input terminal 10 which is coupled to the non inverting input of comparator 12. The D.C. offset of comparator 12 is created by coupling the inverting input of the comparator 12 to the center point of a voltage divider comprised of resistors 16 and 18 disposed in series between a stable reference voltage Vref coupled to a terminal 14 and ground. The actual D.C. offset voltage of the comparator is determined by the voltage divider ratio of the resistors 16 and 18 in the conventional manner. The hysteresis band width of the comparator 12 is determined by the value of an injected D.C. offset current. A digital-to-analog converter (DAC) 20 is coupled to the hysteresis width control input of the comparator 12 and generates a desired injection current corresponding to the desired hysteresis band width. A digital control word received on line 24, which can be provided by a microprocessor or digital controller, is used to program the DAC 20. The output of the comparator 12 is coupled to an output terminal 26 labeled Frequency Output which provides the trigger signal to subsequent frequency measurement circuits.

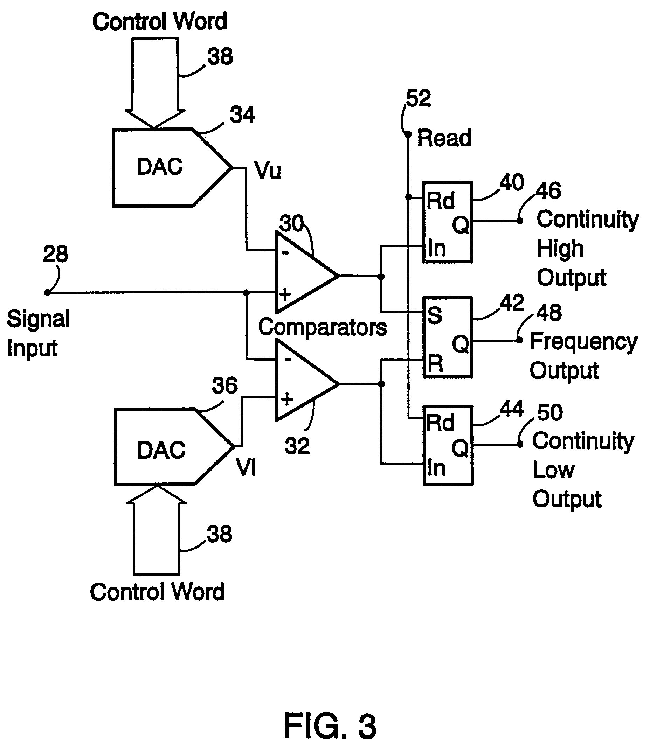

Referring to FIG. 3, there is shown the commercial embodiment of the present invention. The input signal is applied to an input terminal 28 which is coupled to the non inverting input of a comparator 30 and the inverting input of a comparator 32. A digital-to-analog converter (DAC) 34 which serves as a voltage reference for upper limit voltage Vu is coupled to the inverting input of the comparator 30. A digital-to-analog converter (DAC) 36 which serves as a voltage reference for lower limit voltage Vl is coupled to the non inverting input of the comparator 32. A digital control word received on a line 38, which can be provided by a microprocessor or digital controller, is used to program the DAC 34 and the DAC 36. A first input of a bistable circuit 42 is coupled to the output of comparator 30. A second input of bistable circuit 42 is coupled to the output of comparator 32. As the input voltage passes above the upper limit voltage set by DAC 34, the comparator 30 provides a digital "high" to the first input of bistable circuit 42 thereby setting its output "high". The digital "high" and "low" voltage levels correspond to industry-standard definitions for appropriate logic families such as TTL or CMOS. As the input signal voltage falls below the lower limit voltage set by DAC 36, the comparator 32 provides a TTL-level "high" to the second input of bistable circuit 42 thereby resetting its output "low". An output of bistable circuit 42 is coupled to an output terminal 48 labeled Frequency Output which provides the trigger signal to subsequent frequency measurement circuits.

With the digital multimeter operating in continuity detecting mode, the input signal voltage level corresponds to a high or a low continuity level between the multimeter test leads, allowing the trigger circuit to provide a continuity detecting function. DAC 34 is set to a specified upper limit voltage to detect an "open" circuit between the multimeter test leads corresponding to a higher input signal level and DAC 36 is set to a specified lower signal level to detect a "short" circuit between the multimeter test leads corresponding to a lower input voltage level. An input of latch 40 is coupled to the output of the comparator 30. An input of latch 44 is coupled to the output of comparator 32. A read pulse is coupled to a terminal 52 which is coupled to latches 40 and 42 in order to enable the latches to store an output state of comparators 30 and 32 respectively when the read pulse is provided every 25 milliseconds. The outputs of the latch 40 and the latch 44 are coupled to output terminals 46 and 50 respectively which are in turn coupled to a microprocessor which enables or disables an audio tone responsive to the states stored in the latches 40 and 44.

It will be obvious to those having ordinary skill in the art that many changes may be made in the details of the above described preferred embodiments of the invention without departing from the spirit of the invention in its broader aspects. For example, a precision resistor network could be implemented in place of the DAC 34 and DAC 36 to select the upper and lower limits of the hysteresis band with attendant reduction in versatility. A commonly available reset-set (RS) flip flop or J-K flip flop could be implemented in place of the bistable circuit 42. Therefore, the scope of the present invention should be determined by the following claims.

## Claims

1. A trigger circuit comprising:
(a) a first voltage source for providing an upper limit voltage;
(b) a second voltage source for providing a lower limit voltage;
(c) a first comparator having a first input coupled to said first voltage source and a second input coupled to an input signal to provide an upper limit signal at an output when the voltage of said input signal is above said upper limit voltage;
(d) a second comparator having a first input coupled to said second voltage source and a second input coupled to said input signal to provide a lower limit signal at an output when the voltage of said input signal is below said lower limit voltage; and
(e) a bistable circuit having a first input coupled to said output of said first comparator and a second input coupled to said output of said second comparator, said bistable circuit responsive to said upper limit signal and said lower limit signal to provide a trigger signal.

2. A trigger circuit in accordance with claim 1 further comprising:
(a) a first latch coupled to the output of said first comparator to store an output state of said first comparator to provide for continuity detection; and
(b) a second latch coupled to the output of said second comparator to store an output state of said second comparator to provide for continuity detection.

3. A trigger circuit in accordance with claim 1 wherein said first and second voltage reference source comprise programmable digital-to-analog converters.

4. A trigger circuit in accordance with claim 1 wherein said bistable circuit comprises a reset-set (RS) flip flop.

5. A trigger circuit comprising:
(a) a first voltage source comprising a programmable digital-to-analog converter for providing an upper limit voltage;
(b) a second voltage source comprising a programmable digital-to-analog converter for providing a lower limit voltage;
(c) a first comparator having a first input coupled to said first voltage source and a second input coupled to an input signal to provide an upper limit signal at an output when the voltage of said input signal is above said upper limit voltage;
(d) a second comparator having a first input coupled to said second voltage source and a second input coupled to said input signal to provide a lower limit signal at an output when the voltage of said input signal is below said lower limit voltage;
(e) a bistable circuit having a first input coupled to said output of said first comparator and a second input coupled to said output of said second comparator, said bistable circuit responsive to said upper limit signal and said lower limit signal to provide a trigger signal;
(f) a first latch coupled to the output of said first comparator to store an output state of said first comparator to provide for continuity detection; and
(g) a second latch coupled to the output of said second comparator to store an output state of said second comparator to provide for continuity detection.

6. A frequency measuring circuit wherein a first comparator is used to determine whether an input signal has exceeded a first setable threshold, and a second comparator is used to determine whether the input signal has exceeded a second setable threshold, and wherein an output having a frequency corresponding to that of the input signal is produced in response to the outputs of the first and second comparators.

7. A continuity test circuit, wherein a first comparator is used to determine whether an input signal has exceeded a first setable threshold, and a second comparator is used to determine whether the input signal has exceeded a second setable threshold, means being provided to latch each comparator output, whereby a continuity state is indicated by the state of the latch means.
